(19)

**Europäisches Patentamt**
**European Patent Office**
**Office européen des brevets**

(11) **EP 4 089 423 B1**

(12) **EUROPÄISCHE PATENTSCHRIFT**

(45) Veröffentlichungstag und Bekanntmachung des Hinweises auf die Patenterteilung:
**18.10.2023 Patentblatt 2023/42**

(21) Anmeldenummer: **22170262.4**

(22) Anmeldetag: **27.04.2022**

(51) Internationale Patentklassifikation (IPC):
**G01R 27/18** (2006.01)   **G01R 31/52** (2020.01)
**G01R 31/50** (2020.01)

(52) Gemeinsame Patentklassifikation (CPC):
**G01R 27/18; G01R 31/52**

(54) **VERFAHREN UND MESSVORRICHTUNG ZUM ERMITTELN EINES ABLEITSTROMS IN EINEM UNGEERDETEN, EINPHASIGEN WECHSELSTROM-STROMVERSORGUNGSSYSTEM**

METHOD AND MEASURING DEVICE FOR DETERMINING A LEAKAGE CURRENT IN AN UNCONTROLLED SINGLE-PHASE AC POWER SUPPLY SYSTEM

PROCÉDÉ ET DISPOSITIF DE MESURE PERMETTANT DE DÉTERMINER UN COURANT DE FUITE DANS UN SYSTÈME D'ALIMENTATION EN COURANT ALTERNATIF MONOPHASÉ NON MIS À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.05.2021 DE 102021111858**

(43) Veröffentlichungstag der Anmeldung:
**16.11.2022 Patentblatt 2022/46**

(73) Patentinhaber: **Bender GmbH & Co. KG**
**35305 Grünberg (DE)**

(72) Erfinder:
• **REITZ, Julian**
**35305 Grünberg (DE)**

• **BRÖCKMANN, Eckhard**
**35396 Gießen (DE)**
• **HACKL, Dieter**
**35463 Fernwald (DE)**
• **SCHEPP, Karl**
**35447 Reiskirchen (DE)**

(74) Vertreter: **advotec.**
**Patent- und Rechtsanwaltspartnerschaft Tappe mbB**
**Georg-Schlosser-Straße 6**
**35390 Gießen (DE)**

(56) Entgegenhaltungen:
**EP-A1- 3 641 087    DD-A1- 256 925**

**Beschreibung**

Die Erfindung betrifft ein Verfahren sowie eine Messvorrichtung zum Ermitteln eines Ableitstroms in einem ungeerdeten, einphasigen Wechselstrom-Stromversorgungssystem.

Im Rahmen von Inbetriebnahmeprüfungen und wiederkehrenden Prüfungen an Stromversorgungssystemen und elektrischen Anlagen sind hinsichtlich der elektrischen Sicherheit bestimmte Ausführungsstandards vorgeschrieben und durch Messungen nachzuweisen.

Eine speziell das ungeerdete Stromversorgungssystem (frz. Isolé Terre - IT-Netz) betreffende Messung besteht in der Bestimmung des Ableitstroms. Der Zweck dieser Maßnahme liegt in der Bestimmung einer maximal möglichen Berührspannung, welche aus dem Produkt des Ableitstroms und dem Erdungswiderstand ergibt. Gemäß der Norm DIN VDE 0100-410/IEC 60364-4-41:205 muss dieser Spannungswert für Wechselstrom-Stromversorgungssysteme ≤ 50V sein.

Aus dem Stand der Technik sind gemäß DIN VDE 0100-600 / IEC60364-6:2016 Methoden zur Ermittlung des Ableitstroms bekannt. Danach kann die Ermittlung des Ableitstroms entweder durch Berechnung mit bekannten Parametern (Ableitkapazität, Isolationswiderstand) oder durch Messung erfolgen. Für die Messung werden zwei Methoden genannt, wobei für beide Methoden ein Erdschluss zwischen einem der Außenleiter und Erde (Erdpotential) geschaltet werden muss. Dabei kann zum einen der Strom infolge des durch eine Strommesseinrichtung (Strommessgerät, Amperemeter) bewusst herbeigeführten Erdschlusses gemessen werden. Alternativ ist die Berührspannung zu messen, wobei die Spannung zwischen dem Erdungspunkt des Stromversorgungssystems und einer gesonderten Erdverbindung, beispielsweise einem Fundamenterder, gemessen wird. Stand der Technik findet sich zum Beispiel in den Dokumenten EP3641087A1 und DD256925A1.

Je umfangreicher allerdings ein ungeerdetes Stromversorgungssystem aufgebaut ist, desto aufwendiger gestaltet sich die Berechnung des Ableitstroms, da viele Einflussgrößen nicht bekannt sein werden. Darüber hinaus stellt auch die Messung eine Personengefährdung dar, weil ein zweiter Fehler - neben dem durch das Strommessgerät verursachten ersten Fehler - bei einer bestehenden einseitigen Erdung unbedingt ausgeschlossen werden muss und zudem beim Durchführen der Erdung hohe kapazitive Umladeströme fließen können. Auch können bei einer ungeeigneten Kontaktierung Lichtbögen entstehen.

Die normativ vorgegebenen Erdschlüsse stellen daher neben der Personengefährdung auch stets eine Gefahr der Beschädigung der elektrischen Anlage dar.

Der vorliegenden Erfindung liegt somit die Aufgabe zugrunde, ein Verfahren und eine Messvorrichtung vorzuschlagen, die die Ableitstrommessung in einem ungeerdeten Wechselstrom-Stromversorgungssystem ohne Personengefährdung und ohne Gefahr der Beschädigung der elektrischen Anlage ermöglichen.

Diese Aufgabe wird durch ein Verfahren gemäß Anspruch 1 gelöst.

In einem ersten Schritt wird ein veränderlicher Prüf-Widerstand zwischen einen der Außenleiter und Erde geschaltet, wobei ein Prüf-Widerstandswert unendlich einzustellen ist.

Mit diesem Schritt wird zunächst die Voraussetzung einer Installation des veränderlichen Prüf-Widerstands in dem Wechselstrom-Stromversorgungssystems geschaffen. Der veränderliche Prüf-Widerstand ist zunächst auf einen (maximalen) Prüf-Widerstandswert unendlich eingestellt und entspricht damit einem Leerlauf an offenen Klemmen des veränderlichen Prüf-Widerstands, wo eine Außenleiter-Erde-Spannung zwischen dem Außenleiter und Erde zur Verfügung steht.

Mittels einer Netzspannungs-Messeinrichtung erfolgt anschließend das Messen einer Betriebsspannung des Wechselstrom-Stromversorgungssystems zwischen den Außenleitern.

Dieser Messvorgang ist erforderlich, falls die Betriebsspannung nicht genau bekannt ist.

Mittels einer Erdspannungs-Messeinrichtung wird anschließend eine Außenleiter-Erde-Spannung zwischen einem der Außenleiter und Erde gemessen.

Diese Messung kann an den noch offenen Klemmen des veränderlichen Prüf-Widerstands als Leerlauf-Spannungsmessung durchgeführt werden, wobei die Reihenfolge der Messung der Betriebsspannung und der Messung der Außenleiter-Erde-Spannung auch vertauschbar ist.

Falls die Bedingung, dass die gemessene Außenleiter-Erde-Spannung größer oder gleich der halben Betriebsspannung ist, nicht erfüllt ist, wird der veränderliche Prüf-Widerstand zwischen die anderen Außenleiter und Erde geschaltet.

Damit ist gewährleistet, dass das Einbringen des veränderlichen Prüf-Widerstands an dem Außenleiter mit der größeren Außenleiter-Erde-Spannung erfolgt und somit zu einem höheren Strom führt, was sich wiederum aufgrund des besseren Signal-Rauschleistungs-Verhältnisses in höherer Genauigkeit bei nachfolgenden numerischen Berechnungen äußert.

Es erfolgt eine Bestimmung eines minimal zulässigen Prüf-Widerstandswertes für den veränderlichen Prüf-Widerstand.

Dieser minimal zulässige Prüf-Widerstandswert wird beispielsweise so festgelegt, dass das Ansprechen einer vorhandenen Fehlerstrom-Schutzeinrichtung vermieden wird und beträgt zum Beispiel 5 kΩ.

Anschließend erfolgt ein Bestimmen von mindestens drei Stütz-Prüf-Widerstandswerten als Stützstellen ausgehend von dem minimal zulässigen Prüf-Widerstandswert.

Geeignete Stütz-Prüf-Widerstandswerte sind beispielhaft 5 kΩ (minimal zulässiger Prüf-Widerstandswert), 10 kΩ, 15kΩ 20 kΩ, 25 kΩ. Eine hohe Anzahl von Stütz-Prüf-Widerstandswerten erhöht zwar die Prüfdauer, verbessert jedoch die Störresistenz des Verfahrens.

Dann erfolgt ein Einstellen der Stütz-Prüf-Widerstandswerte und Messen eines sich jeweils ergebenden gemessenen Prüfstroms durch den veränderlichen Prüf-Widerstand mittels einer Strommesseinrichtung.

Die zuvor festgelegten Stütz-Prüf-Widerstandswerte werden sukzessive eingestellt, also der veränderlichen Prüf-Widerstand mit dem entsprechenden Stütz-Prüf-Widerstandswert aufgeschaltet, um eine funktionale messtechnische Abhängigkeit zwischen dem eingestellten Stütz-Prüf-Widerstandswert und dem sich bei dem jeweiligen Stütz-Prüf-Widerstandswert ergebenden gemessenen Prüfstrom ermitteln zu können.

Das Wechselstrom-Stromversorgungssystem wird durch ein Ersatzschaltbild mit dem Prüf-Widerstand und mit Ableitimpedanzen, welche als kapazitiven Anteil Ableitkapazitäten des Wechselstrom-Stromversorgungssystems umfassen, abgebildet.

Das Ersatzschaltbild spiegelt als Modell des Wechselstrom-Stromversorgungssystems dessen elektrisches Verhalten hinsichtlich des zu ermittelten Ableitstroms wider.

Auf der Grundlage dieses Ersatzschaltbildes erfolgt ein Bestimmen der Ableitkapazitäten aus einem das Ersatzschaltbild beschreibenden Gleichungssystem mittels eines numerischen Näherungsverfahrens so, dass die Abweichung eines berechneten Prüfstroms von dem gemessenen Prüfstrom an den Stützstellen (Stütz-Prüf-Widerstandswerten) minimiert wird.

Das in dem Ersatzschaltbild modellierte Wechselstrom-Stromversorgungssystem kann mittels Knotenpunkt- und Maschengleichungen in ein Gleichungssystem überführt werden, welches die Abhängigkeit von Strömen und Spannungen, insbesondere des durch den Prüf-Widerstand fließenden Prüfstroms von der Betriebsspannung, beschreibt.

Die noch unbekannten Größen (Impedanzen) des Gleichungssystems werden durch typische Werte ersetzt (ohmsche Anteile), so dass als relevante unbekannte Parameter die Ableitkapazitäten (kapazitive Anteile) verbleiben, die durch ein numerisches Näherungsverfahren bestimmt werden.

Abschließend erfolgt das Berechnen des Ableitstroms als berechneter Prüfstrom aus dem Gleichungssystem mit den ermittelten Ableitkapazitäten und mit dem Prüf-Widerstandswert Null.

Diese Extrapolation auf den Prüf-Widerstandswert Null führt zu einem berechneten Prüfstrom, der dem zu ermittelnden Ableitstrom entspricht. Es wird somit eine Erdschlusssituation nachgebildet ohne einen gefährdenden Erdschluss selbst herbeizuführen, da nur signifikante Prüf-Widerstandswerte aufgeschaltet werden. Hieraus ergibt sich auch der Vorteil, dass elektrische Anlagen zur Ableitstrommessung nicht mehr abgeschaltet werden müssen und die handelnde Person keinem mit dem Herstellen eines Erdschlusses verbundenem Risiko durch elektrischen Schlag oder durch Lichtbögen ausgesetzt ist.

Danach können der Ableitstrom und die Ableitkapazitäten ausgegeben werden.

Das erfindungsgemäße Verfahren ermöglicht nicht nur die Ermittlung des Ableitstroms, sondern auch eine Leiter-selektive Bestimmung der Ableitkapazitäten. Man erhält genaue Informationen über den elektrischen Zustand des ungeerdeten Stromversorgungssystems, da der Kapazitätsmessbereich mit dem Verfahren - im Vergleich zu üblichen Isolationsüberwachungsgeräten, die meist nur Gesamtableitkapazitäten in der Größenordnung von einigen μF bestimmen können - im einstelligen nFbis zum einstelligen μF-Bereich liegt.

In weiterer Ausgestaltung des Verfahrens wird das nummerische Näherungsverfahren nach der Methode der kleinsten Quadrate ausgeführt.

Als Näherungsverfahren wird die aus dem Stand der Technik bekannte Methode der kleinsten Quadrate verwendet (MKQ/LS - Least Squares). Dazu werden die Ableitkapazitäten numerisch derart bestimmt, dass die Summe der quadratischen Abweichung des mit den Näherungswerten berechneten Prüfstroms mit dem gemessenen Prüfstrom an den Stütz-Prüf-Widerstandswerte minimiert wird.

Weiter werden in dem Ersatzschaltbild ohmsche Anteile der Ableitimpedanzen im Sinne eines unendlich großen Widerstandswertes vernachlässigt.

Für die ohmschen Anteile (Isolationswiderstände) der Ableitimpedanzen werden vorteilhafterweise Annahmen getroffen. Die Isolationswiderstände können dabei in guter Näherung als Leerlauf betrachtet werden, da die Ableitstrommessung nur an einem ungeerdeten Stromversorgungsnetz mit intakter Isolierung, also Isolationswiderstandswerten von ≥ 1 MΩ, durchgeführt werden soll.

Die Ankoppelwiderstände eines Isolationsüberwachungsgerätes (IMD) werden dabei auf in der Praxis gängige Werte gesetzt oder bei Bekanntheit durch genaue Werte hinterlegt.

Mit Vorteil wird der Verfahrensablauf automatisiert von einer Recheneinheit ausgeführt.

Dabei kann das Verfahren auf einer entsprechend konfigurierten Recheneinheit zyklisch automatisiert und auch ferngesteuert durchgeführt werden, was für den Anlagenbetreiber eine Kostenersparnis bedeutet und die Benutzerfreundlichkeit sowie die Betriebssicherheit erhöht.

Die der Erfindung zugrundeliegende Aufgabe wird weiterhin gelöst durch eine Messvorrichtung mit den Merkmalen gemäß Anspruch 5.

Die Messvorrichtung weist dazu einen veränderlichen Prüf-Widerstand auf, der an einen der Außenleiter und an Erde geschaltet werden kann.

Der veränderliche Prüf-Widerstand ist entsprechend der Messung der Betriebsspannung mit einem der Außenleiter verbunden.

Die Messvorrichtung umfasst eine Netzspannungs-Messeinrichtung zum Messen einer Betriebsspannung des Wechselstrom-Stromversorgungssystems zwischen den Außenleitern und eine Erdspannungs-Messeinrichtung zum Messen einer Außenleiter-Erde-Spannung zwischen einem der Außenleiter und Erde sowie eine Strommesseinrichtung zum Messen eines sich einstellenden gemessenen Prüfstroms durch den veränderlichen Prüf-Widerstand.

Die Messvorrichtung umfasst weiterhin eine Recheneinheit, welche konfiguriert ist zur Steuerung und Ausführung des in Anspruch 1 beanspruchten Verfahrensablaufs. Die Recheneinheit ist vorzugsweise als Mikroprozessor ausgeführt.

In weiterer Ausgestaltung der Messvorrichtung sind der veränderliche Prüf-Widerstand, die Erdspannungs-Messeinrichtung, die Strommesseinrichtung und die Recheneinheit als eine bauliche Einheit ausgebildet.

Auch kann diese bauliche Einheit durch Integration der Netzspannungs-Messeinrichtung zu einer erweiterten baulichen Einheit ausgebildet sein.

Weiterhin ist der veränderliche Prüf-Widerstand als Widerstandsmesswert mit diskret schaltbaren Widerstandswerten oder als elektronischer Widerstand mit Halbleiterbauelementen ausgeführt.

Die beanspruchten strukturellen Merkmale der erfindungsgemäßen Messvorrichtung setzen die entsprechenden Verfahrensschritte des erfindungsgemäßen Verfahrens um. Somit treffen die für das Verfahren geltenden Vorteile gleichermaßen auch auf die Messvorrichtung zu.

Weitere vorteilhafte Ausgestaltungsmerkmale ergeben sich aus der nachfolgenden Beschreibung und den Zeichnungen, die eine Ausführungsform der Erfindung anhand von Beispielen erläutern.

Es zeigen:

**Fig. 1** eine Ableitstrommessung nach dem Stand der Technik,

**Fig. 2** eine erfindungsgemäße Messvorrichtung zum Ermitteln eines Ableitstroms und

**Fig. 3** ein Ersatzschaltbild zum Ermitteln des Ableitstroms.

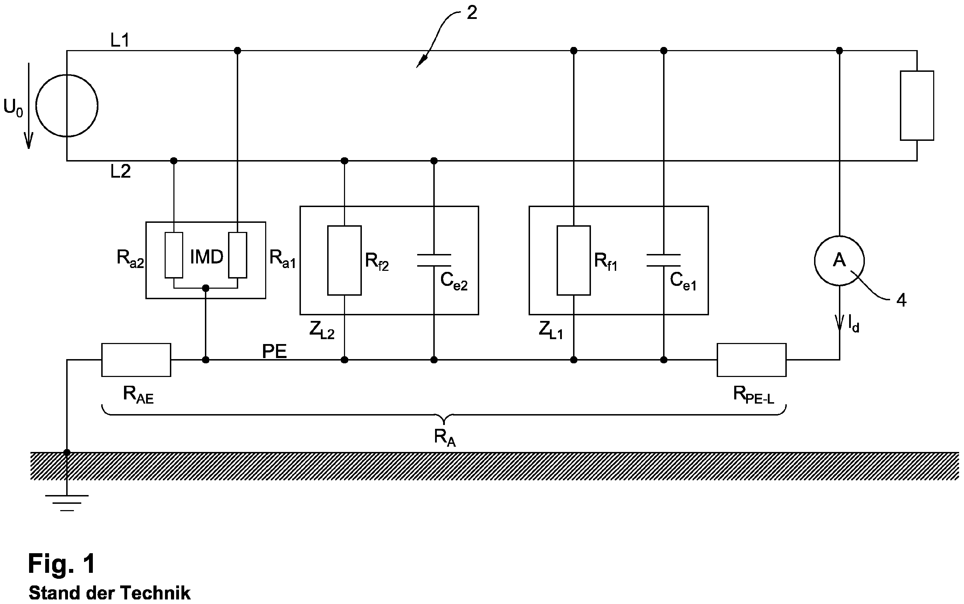

**Fig. 1** zeigt in einem funktionalen Schaltbild ein aus dem Stand der Technik bekanntes Verfahren zur Messung des Ableitstroms $I_d$ in einem einphasigen Wechselstrom-Stromversorgungssystem 2 mit Außenleitern L1, L2 und einer Betriebsspannung $U_0$.

Definitionsgemäß sind alle aktiven Teile des ungeerdeten Wechselstrom-Stromversorgungssystems 2 von Erde PE getrennt, jedoch weist das ungeerdete Wechselstrom-Stromversorgungssystems 2 unvermeidbare Ableitimpedanzen $Z_{L1}$, $Z_{L2}$ der Außenleiter L1, L2 gegenüber Erde PE auf. Die Ableitimpedanzen $Z_{L1}$, $Z_{L2}$ setzen sich aus einem ohmschen Anteil $R_{f1}$, $R_{f2}$ (Isolationswiderstand) und einem kapazitiven Anteil $C_{e1}$, $C_{e2}$ (Ableitkapazitäten) zusammen. Ein Erdungswiderstand $R_A$ besteht aus der Summe der Widerstände des Erders $R_{AE}$ und des Schutzleiters $R_{PE-L}$.

Zur normgemäß vorgeschriebenen Isolationsüberwachung ist ein Isolationsüberwachungsgerät IMD mit den Ankoppelwiderständen $R_{a1}$, $R_{a2}$ zwischen jeweils einen der Außenleiter L1, L2 und Erde PE geschaltet.

Dem Stand der Technik gemäß erfolgt die Messung des Ableitstroms $I_d$, indem ein Amperemeter 4 mit dem Innenwiderstand Null zwischen den Außenleiter L1 und Erde PE geschaltet wird. Der so bewusst herbeigeführte Erdschluss stellt allerdings eine Gefahrenquelle für die handelnde Person ebenso wie für die elektrische Anlage dar, weil bei einem möglichen zweiten Fehler (Erdschluss an dem anderen Außenleiter L2) hohe kapazitive Umladeströme fließen oder Lichtbögen entstehen können.

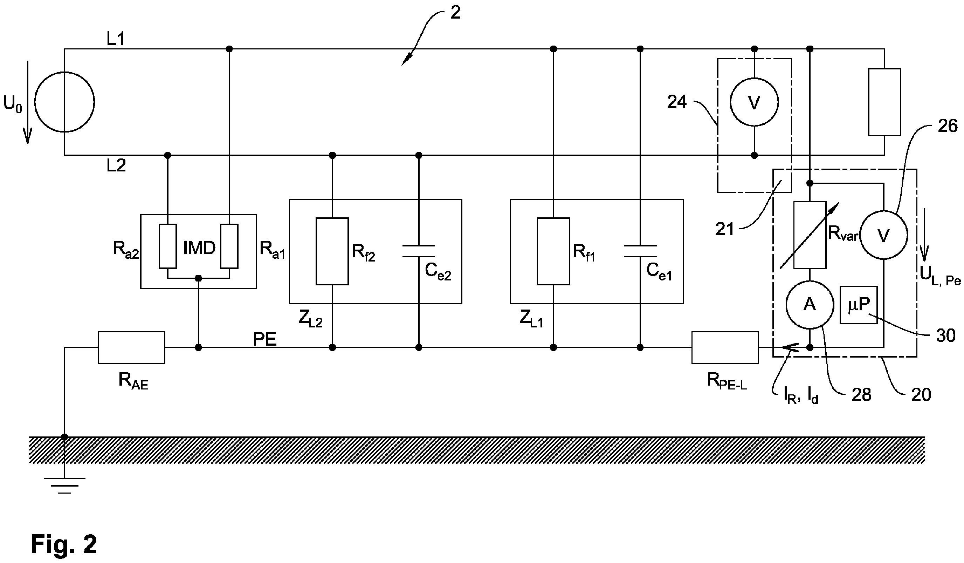

**Fig. 2** veranschaulicht eine erfindungsgemäße Messvorrichtung 20, 21 zur Ermittlung des Ableitstroms $I_d$ in einen ungeerdeten, einphasigen Wechselstrom-Stromversorgungssystem 2.

Die erfindungsgemäße Messvorrichtung 20, 21 umfasst einen veränderlichen Prüf-Widerstand $R_{var}$, der zwischen einen der Außenleiter L1, L2 - vorliegend der Außenleiter L1 - geschaltet wird. Die Bezeichnung $R_{var}$ wird im Folgenden sowohl für den elektrischen Widerstand als körperlicher Gegenstand (Prüf-Widerstand) als auch für die diesem Prüf-Widerstand zugeordnete (kontinuierliche) physikalische Größe (Prüf-Widerstandswert) verwendet.

Die erfindungsgemäße Messvorrichtung 20, 21 umfasst weiter eine Strommesseinrichtung 28, mittels der ein sich für einen vorgegebenen Prüf-Widerstandswert $R_{var}$ einstellende gemessene Prüfstrom $I_R$ durch den veränderlichen Prüf-Widerstand $R_{var}$ erfasst wird.

Eine Erdspannungs-Messeinrichtung 26 der erfindungsgemäßen Messvorrichtung 20, 21 misst eine Außenleiter-Erde-Spannung $U_{L,Pe}$ zwischen dem Außenleiter L1 und Erde PE, wobei für den Außenleiter L1 gilt, dass $U_{L,Pe} \geq U_0/2$ ist.

Eine Recheneinheit 30 der erfindungsgemäßen Messvorrichtung 20, 21 ist konfiguriert zur Steuerung des Verfahrensablaufs sowie zur Ausführung der Berechnungen und kann über eine Fernsteuerung verfügen.

Der veränderliche Prüf-Widerstand $R_{var}$, die Erdspannungs-Messeinrichtung 26, die Strommesseinrichtung 28 und die Recheneinheit 30 können als eine bauliche Einheit 20 ausgebildet sein.

Eine Netzspannungs-Messeinrichtung 24 dient zum Messen einer Betriebsspannung $U_0$ des Wechselstrom-Stromversorgungssystems 2 zwischen den Außenleitern L1, L2.

Die Netzspannungs-Messeinrichtung 24 kann zusammen mit dem veränderlichen Prüf-Widerstand $R_{var}$, der Erdspannungs-Messeinrichtung 26, der Strommesseinrichtung 28 und der Recheneinheit 30 zu einer erweiterten baulichen Einheit (21) integriert werden.

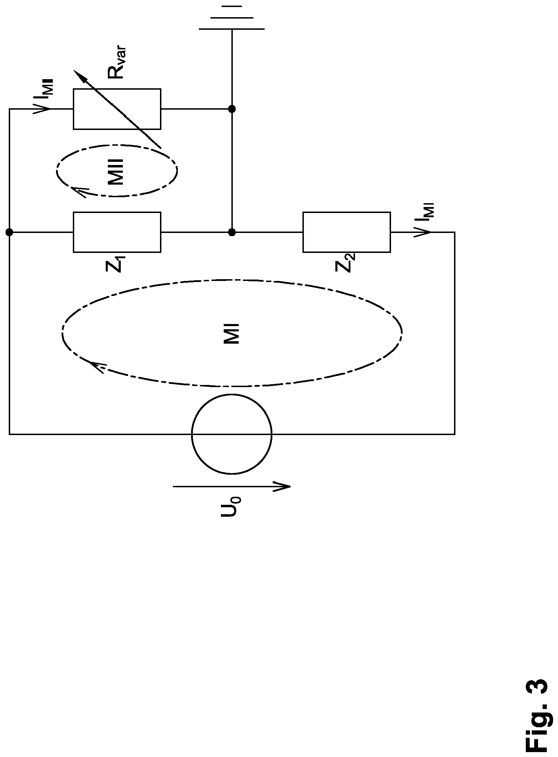

**Fig. 3** zeigt ein Ersatzschaltbild zur Ermittlung des Ableitstroms $I_d$. Dabei wird das Wechselstrom-Stromversorgungssystem 2 in einem Impedanz-Netzwerk mit den Gesamtimpedanzen $Z_1$, $Z_2$ und dem veränderlichen Prüf-Widerstand $R_{var}$ sowie der Betriebsspannung $U_0$ modelliert.

Die Gesamtimpedanzen $Z_1$ und $Z_2$ fassen gemäß Gleichung (1) die einzelnen elektrischen Komponenten zwischen den Außenleitern L1, L2 und Erde PE jeweils zu der Gesamtimpedanz $Z_1$, $Z_2$ zusammen.

$$\begin{bmatrix} Z_1 \\ Z_2 \end{bmatrix} = \begin{bmatrix} R_{a1} \,||R_{f1}\,||X_{Ce1} \\ R_{a2}\,||R_{f2}\,||X_{Ce2} \end{bmatrix} \qquad (1)$$

Die Gesamtimpedanz $Z_1$ ergibt sich somit aus der Parallelschaltung des ohmschen Widerstands $R_{a1}$ (Ankoppelwiderstand des Isolationsüberwachungsgerätes IMD) und der Ableitimpedanz $Z_{L1}$, welche sich aus dem ohmschen Anteil $R_{f1}$ (Isolationswiderstand) sowie der Reaktanz $X_{Ce1}$ (entsprechend der Ableitkapazität $C_{e1}$) zusammensetzt. Entsprechendes gilt für die Gesamtimpedanz $Z_2$.

Aus den Maschengleichungen MI, MII und einer Knotengleichung ergibt sich aus dem Ersatzschaltbild das Gleichungssystem nach Gleichung (2).

$$\begin{bmatrix} Z_1 + Z_2 & -Z_1 \\ -Z_1 & Z_1 + R_{var} \end{bmatrix} \cdot \begin{bmatrix} I_{MI} \\ I_{MII} \end{bmatrix} = \begin{bmatrix} U_0 \\ 0 \end{bmatrix} \qquad (2)$$

mit

$$I_R = I_{MII} \qquad (3)$$

Das Gleichungssystem beschreibt den analytischen Zusammenhang zwischen dem gemessenen Prüfstrom $I_R$ in Abhängigkeit des veränderlichen Prüf-Widerstandswert $R_{var}$.

Aus den Messungen sind für die bekannten Stütz-Prüf-Widerstandswerte $R_{var,i}$ die sich jeweils einstellenden gemessenen Prüfströme $I_{Ri}$ bekannt. Es liegt damit ein Ersatzschaltbild-Modell der Messanordnung vor - die Parameter $R_{a1}$, $R_{a2}$, $R_{f1}$, $R_{f2}$, $X_{Ce1}$, $X_{Ce2}$ sind jedoch zunächst unbekannt (Grey-Box-Modell). Für die ohmschen Anteile $R_{a1}$, $R_{a2}$, $R_{f1}$, $R_{f2}$ werden daher Annahmen getroffen. Die Isolationswiderstände $R_{f1}$ und $R_{f2}$ werden wegen der Voraussetzung einer intakten Isolierung als unendlich angenommen. Die Ankoppelwiderstände $R_{a1}$, $R_{a2}$ des Isolationsüberwachungsgerätes IMD können auf in der Praxis gängige Werte gesetzt oder bei Bekanntheit als genaue Werte implementiert werden. Somit sind die Ableitkapazitäten $C_{e1}$ und $C_{e2}$ als unbekannte Größen die für den gemessenen Prüfstrom $I_R$ maßgeblich relevanten Parameter.

Mittels eines nummerischen Näherungsverfahrens werden die Ableitkapazitäten $C_{e1}$ und $C_{e2}$ so bestimmt, dass die Abweichung eines berechneten, approximierten Prüfstroms $I_{R,fit}$, $I_{Ri,fit}$ von dem gemessenen Prüfstrom $I_{Ri}$ an den Stütz-Prüfwiderstandswerten $R_{var,i}$ (Stützstellen) in den Stützpunkten $I_{Ri}(R_{var,i})$ minimiert wird.

Dies gelingt mit der Anwendung der Methode der kleinsten Quadrate gemäß Gleichung (4).

$$\sum_{i=1}^{n} \left( \frac{I_{Ri}(R_{var,i}) - I_{Ri,fit}(R_{var,i}, C_{e1}, C_{e2})}{I_{Ri,fit}(R_{var,i}, C_{e1}, C_{e2})} \right)^2 \to min \qquad (4)$$

Mit den so ermittelten Ableitkapazitäten $C_{e1}$, $C_{e2}$, kann nun mit den Gleichungen (2), (3) und $I_R=I_d$ der Ableitstrom $I_d$ als berechneter Prüfstrom $I_{R0,fit}$, und Nullsetzen des Prüf-Widerstandswertes $R_{var}$ bestimmt werden.

**Patentansprüche**

1. Verfahren zum Ermitteln eines Ableitstroms ($I_d$) in einem ungeerdeten, einphasigen Wechselstrom-Stromversorgungssystem (2) mit zwei Außenleitern (L1, L2), umfassend die Verfahrensschritte:

   **a)** Schalten eines veränderlichen Prüf-Widerstands ($R_{var}$) zwischen einen der Außenleiter (L1, L2) und Erde (PE), wobei ein Prüf-Widerstandswert unendlich einzustellen ist,
   b) Messen einer Betriebsspannung ($U_0$) des Wechselstrom-Stromversorgungssystems (2) zwischen den Außenleitern (L1, L2) mittels einer Netzspannungs-Messeinrichtung (24),
   c) Messen einer Außenleiter-Erde-Spannung ($U_{L,Pe}$) zwischen einem der Außenleiter (L1, L2) und Erde (PE) mittels einer Erdspannungs-Messeinrichtung (26),
   d) Falls die Bedingung, dass die Außenleiter-Erde-Spannung ($U_{L,Pe}$) größer oder gleich der halben Betriebsspannung ($U_0$) ist, nicht erfüllt ist, Schalten des veränderlichen Prüf-Widerstands ($R_{var}$) zwischen den anderen Außenleiter (L1, L2) und Erde (PE),
   e) Bestimmen eines minimal zulässigen Prüf-Widerstandswertes ($R_{var,min}$) für den veränderlichen Prüf-Widerstand ($R_{var}$),
   f) Bestimmen von mindestens drei Stütz-Prüfwiderstandswerten ($R_{var,i}$) als Stützstellen ausgehend von dem minimal zulässigen Prüf-Widerstandswert ($R_{var,min}$),
   g) Einstellen der Stütz-Prüfwiderstandswerte ($R_{var,i}$) und Messen eines sich jeweils ergebenden gemessenen Prüfstroms ($I_R$, $I_{Ri}$) durch den veränderlichen Prüf-Widerstand ($R_{var}$) mittels einer Strommesseinrichtung (28) zum Ermitteln einer funktionalen messtechnischen Abhängigkeit des gemessenen Prüfstroms ($I_{Ri}$) von dem Stütz-Prüfwiderstandwert ($R_{var,i}$),
   h) Abbilden des Wechselstrom-Stromversorgungssystems (2) durch ein Ersatzschaltbild mit dem Prüf-Widerstand ($R_{var}$) und mit Ableitimpedanzen ($Z_{L1}$, $Z_{L2}$), welche als kapazitiven Anteil Ableitkapazitäten ($C_{e1}$, $C_{e2}$) des Wechselstrom-Stromversorgungssystems (2) umfassen,
   i) Bestimmen der Ableitkapazitäten ($C_{e1}$, $C_{e2}$) aus einem das Ersatzschaltbild beschreibenden Gleichungssystem mittels eines numerischen Näherungsverfahrens so, dass die Abweichung eines berechneten Prüfstroms ($I_{R,fit}$, $I_{Ri,fit}$) von dem gemessenen Prüfstrom ($I_{Ri}$) an den Stütz-Prüfwiderstandwerten ($R_{var,i}$) minimiert wird,
   j) Berechnen des Ableitstroms ($I_d$) als berechneter Prüfstrom ($I_{R,fit}$, $I_{R0,fit}$) aus dem Gleichungssystem mit den ermittelten Ableitkapazitäten ($C_{e1}$, $C_{e2}$) und mit dem Prüf-Widerstandswert ($R_{var}$, $R_0$) Null, Ausgeben des Ableitstroms ($I_d$) und der Ableitkapazitäten ($C_{e1}$, $C_{e2}$).

2. Verfahren nach Anspruch 1,
   **dadurch gekennzeichnet,**
   **dass** das numerische Näherungsverfahren nach der Methode der kleinsten Quadrate ausgeführt wird.

3. Verfahren nach Anspruch 1 oder 2,
   **dadurch gekennzeichnet,**
   **dass** in dem Ersatzschaltbild ohmsche Anteile ($R_{f1}$, $R_{f2}$) der Ableitimpedanzen ($Z_{L1}$, $Z_{L2}$) im Sinne eines unendlich großen Widerstandswertes vernachlässigt werden.

4. Verfahren nach einem der Ansprüche 1 bis 3,
   **dadurch gekennzeichnet,**
   **dass** der Verfahrensablauf automatisiert von einer Recheneinheit (30) ausgeführt wird.

5. Messvorrichtung (20, 21) zum Ermitteln eines Ableitstroms ($I_d$) in einem ungeerdeten, einphasigen Wechselstrom-Stromversorgungssystem (2) mit zwei Außenleitern (L1, L2),
   umfassend

   einen veränderlichen Prüf-Widerstand ($R_{var}$), der an einen der Außenleiter (L1, L2) und an Erde (PE) und geschaltet werden kann, eine Netzspannungs-Messeinrichtung (24) zum Messen einer Betriebsspannung ($U_0$) des Wechselstrom-Stromversorgungssystems (2) zwischen den Außenleitern (L1, L2),
   eine Erdspannungs-Messeinrichtung (26) zum Messen einer Außenleiter-Erde-Spannung ($U_{L,Pe}$) zwischen einem der Außenleiter (L1, L2) und Erde (PE),
   eine Strommesseinrichtung (28) zum Messen eines sich einstellenden gemessenen Prüfstroms ($I_R$, $I_{Ri}$) durch den veränderlichen Prüf-Widerstand ($R_{var}$), und mit
   einer Recheneinheit (30), welche konfiguriert ist zur Steuerung und Ausführung des in Anspruch 1 beanspruchten Verfahrensablaufs.

**6.** Messvorrichtung (20, 21) nach Anspruch 5,
**dadurch gekennzeichnet,**
**dass** der veränderliche Prüf-Widerstand ($R_{var}$), die Erdspannungs-Messeinrichtung (26), die Strommesseinrichtung (28) und die Recheneinheit (30) als eine bauliche Einheit (20) ausgebildet sind oder der veränderliche Prüf-Widerstand ($R_{var}$), die Erdspannungs-Messeinrichtung (26), die Strommesseinrichtung (28), die Recheneinheit (30) und die Netzspannungs-Messeinrichtung (24) als eine erweiterte bauliche Einheit (21) ausgebildet sind.

**7.** Messvorrichtung (20, 21) nach Anspruch 5 oder 6,
**dadurch gekennzeichnet,**
**dass** der veränderliche Prüf-Widerstand ($R_{var}$) als Widerstandsnetzwerk mit diskret schaltbaren Widerstandswerten oder als elektronischer Widerstand mit Halbleiter-Bauelementen ausgeführt ist.

**Claims**

**1.** A method for detecting a leakage current ($I_d$) in an ungrounded, single-phase alternating-current power supply system (2) having two outer conductors (L1, L2), the method comprising the following steps:

a) switching a variable test resistance ($R_{var}$) between one of the outer conductors (L1, L2) and ground (PE), a test-resistance value being supposed to be set infinitely,
b) measuring an operating voltage ($U_0$) of the alternating-current power supply system (2) between the outer conductors (L1, L2) by means of line-voltage measuring equipment (24),
c) measuring an outer-conductor-to-ground voltage ($U_{L,Pe}$) between one of the outer conductors (L1, L2) and ground (PE) by means of ground-voltage measuring equipment (26),
d) should the condition that the outer-conductor-to-ground voltage ($U_{L,Pe}$) be greater than or equal to half the operating voltage ($U_0$) not be fulfilled, switching the variable test resistance ($R_{var}$) between the other outer conductor (L1, L2) and ground (PE),
e) determining a minimally admissible test-resistance value ($R_{var,min}$) for the variable test resistance ($R_{var}$),
f) determining at least three support test-resistance values ($R_{var,i}$) as support locations starting from the minimally admissible test-resistance value ($R_{var,min}$),
g) setting the support test-resistance value ($R_{var,i}$) and measuring a correspondingly resulting, measured test current ($I_R$, $I_{Ri}$) via the variable test resistance ($R_{var}$) by means of current measuring equipment (28) for detecting a functional metrological dependency of the measured test current ($I_{Ri}$) of the support test-resistance value ($R_{var,i}$),
h) mapping the alternating-current power supply system (2) via an equivalent circuit having the test resistance ($R_{var}$) and having leakage impedances ($Z_{L1}$, $Z_{L2}$) which have a capacitive portion of leakage capacitances ($C_{e1}$, $C_{e2}$) of the alternating-current power supply system (2),
i) determining the leakage capacitances ($C_{e1}$, $C_{e2}$) from an equations system, which describes the equivalent circuit, by means of a numerical approximation method such that the deviation of a calculated test current ($I_{R,fit}$, $I_{Ri,fit}$) from the measured test current ($I_{Ri}$) is minimized to the support test-resistance values ($R_{var,i}$),
j) calculating the leakage current ($I_d$) as a calculated test current ($In,fit$, $I_{R0,fit}$) from the equations system having the detected leakage capacitances ($C_{e1}$, $C_{e2}$) and having the rest-resistance value ($R_{var}$, $R_0$) zero, outputting the leakage current ($I_d$) and the leakage capacitances ($C_{e1}$, $C_{e2}$).

**2.** The method according to claim 1,
**characterized in that**
the numerical approximation method is executed according to the least-squares function approximation.

**3.** The method according to claim 1 or 2,
**characterized in that**
ohmic portions ($R_{f1}$, $R_{f2}$) of the leakage impedances ($Z_{L1}$, $Z_{L2}$) are neglected in the equivalent circuit in terms of an infinitely large resistance value.

**4.** The method according to any one of the claims 1 to 3,
**characterized in that**
the method sequence is executed automatically by a computing unit (30).

**5.** A measuring device (20, 21) for detecting a leakage current ($I_d$) in an ungrounded, single-phase alternating-current power supply system (2) having two outer conductors (L1, L2), comprising

a variable test resistance ($R_{var}$) which is switched to one of the outer conductors (L1, L2) and ground (PE), line-voltage measuring equipment (24) for measuring an operating voltage ($U_0$) of the alternating-current power supply system (2) between the outer conductors (L1, L2), ground-voltage measuring equipment (26) for measuring an outer-conductor-to-ground voltage ($U_{L,Pe}$) between one of the outer conductors (L1, L2) and ground (PE), current measuring equipment (28) for measuring a settable, measured test current ($I_R$, $I_{Ri}$) via the variable test resistance ($R_{var}$), and having a computing unit (30) which is configured for controlling and executing the method sequence claimed in Claim 1.

6. The measuring device (20, 21) according to claim 5,
   **characterized in that**
   the variable test resistance ($R_{var}$), the ground-voltage measuring equipment (26), the current measuring equipment (28) and the computing unit (30) are realized as a structural unit (20), or **in that** the variable test resistance ($R_{var}$), the ground-voltage measuring equipment (26), the current measuring equipment (28), the computing unit (30) and the line-voltage measuring equipment (24) are realized as an enhanced structural unit (21).

7. The measuring device (20, 21) according to claim 5 or 6,
   **characterized in that**
   the variable test resistance ($R_{var}$) is configured as a resistance network having discretely switchable resistance values or as an electronic resistance having semiconductor structural elements.

**Revendications**

1. Procédé pour la détection d'un courant de fuite ($I_d$) dans un système (2) d'alimentation électrique non mis à la terre, monophasé et en courant alternatif ayant deux conducteurs extérieurs (L1, L2), le procédé comprenant les étapes suivantes :

   a) une étape de commutation d'une résistance de test ($R_{var}$) variable entre un des conducteurs extérieurs (L1, L2) et la terre (PE), une valeur de résistance de test devant être réglée de manière infinie,
   b) une étape de mesure d'une tension de service ($U_0$) du système (2) d'alimentation électrique en courant alternatif entre les conducteurs extérieurs (L1, L2) au moyen d'un équipement (24) de mesurage à tension de réseau,
   c) une étape de mesure d'une tension phase-terre ($U_{L,Pe}$) entre un des conducteurs extérieurs (L1, L2) et la terre (PE) au moyen de l'équipement (26) de mesurage à tension de terre,
   d) si la condition que la tension phase-terre ($U_{L,Pe}$) soit plus grande que ou égale à la moitié de la tension de service ($U_0$) n'est pas remplie, une étape de commutation de la résistance de test ($R_{var}$) variable entre l'autre conducteur extérieur (L1, L2) et la terre (PE),
   e) une étape de détermination d'une valeur ($R_{var,min}$) de résistance de test minimal admissible pour la résistance de test ($R_{var}$) variable,
   f) une étape de détermination d'au moins trois valeurs ($R_{var,i}$) de résistance de test de support comme emplacement de support à partir de la valeur ($R_{var,min}$) de résistance de test minimal admissible,
   g) une étape d'ajustement des valeurs ($R_{var,i}$) de résistance de test de support et une étape de mesure d'un courant de test ($I_R$, $I_{Ri}$) mesuré résultant à chaque fois par la résistance de test ($R_{var}$) variable au moyen d'un équipement (28) de mesurage de courant pour la détection d'une dépendance fonctionnelle métrologique du courant de test ($I_{Ri}$) mesuré à la valeur ($R_{var,i}$) de résistance de test de support,
   h) une étape de reproduction du système (2) d'alimentation électrique en courant alternatif par un schéma équivalent ayant la résistance de test ($R_{var}$) et ayant des impédances de fuite ($Z_{L1}$, $Z_{L2}$) qui ont une partie capacitive des capacitances de fuite ($C_{e1}$, $C_{e2}$) du système (2) d'alimentation électrique en courant alternatif,
   i) une étape de détermination des capacitances de fuite ($C_{e1}$, $C_{e2}$) à partir d'un système d'équation, qui décrit le schéma équivalent, au moyen d'une méthode d'approximation numérique de telle manière que la déviation d'un courant de test ($I_{R,fit}$, $I_{Ri,fit}$) calculé à partir du courant de test ($I_{Ri}$) mesuré est minimalisée aux valeurs ($R_{var,i}$) de résistance de test de support,
   j) une étape de calcul du courant de fuite ($I_d$) comme courant de test ($I_{R,fit}$, $I_{R0,fit}$) calculé à partir du système d'équation ayant les capacitances de fuite ($C_{e1}$, $C_{e2}$) détectées et ayant la valeur de résistance de test ($R_{var,}$

$R_0$) zéro,

une étape de sortie du courant de fuite ($I_d$) et des capacitances de fuite ($C_{e1}$, $C_{e2}$).

2. Procédé selon la revendication 1,
**caractérisé en ce que**
la méthode d'approximation numérique est exécutée selon l'estimation par les moindres carrés.

3. Procédé selon la revendication 1 ou la revendication 2,
**caractérisé en ce que**
des parties ohmiques ($R_{f1}$, $R_{f2}$) des impédances de fuite ($Z_{L1}$, $Z_{L2}$) sont négligées dans le schéma équivalent au sens d'une valeur de résistance infiniment grande.

4. Procédé selon l'une quelconque des revendications 1 à 3,
**caractérisé en ce que**
la séquence de procédé est exécutée automatiquement par une unité de compte (30).

5. Dispositif de mesure (20, 21) pour la détection d'un courant de fuite ($I_d$) dans un système (2) d'alimentation électrique non mis à la terre, monophasé et en courant alternatif ayant deux conducteurs extérieurs (L1, L2),
comprenant

une résistance de test ($R_{var}$) variable qui est commutée à un des conducteurs extérieurs (L1, L2) et à la terre (PE),
un équipement (24) de mesurage à tension de réseau pour la mesure d'une tension de service ($U_0$) du système (2) d'alimentation électrique en courant alternatif entre les conducteurs extérieurs (L1, L2),
un équipement (26) de mesurage à tension de terre pour la mesure d'une tension phase-terre ($U_{L,Pe}$) entre un des conducteurs extérieurs (L1, L2) et la terre (PE),
un équipement (28) de mesurage de courant pour la mesure d'un courant de test ($I_R$, $I_{Ri}$) ajustable mesuré par la résistance de test ($R_{var}$) variable, et ayant
une unité de compte (30) qui est configurée pour le contrôle et pour l'exécution de la séquence de procédé suivant la revendication 1.

6. Dispositif de mesure (20, 21) selon la revendication 5,
**caractérisé en ce que**
la résistance de test ($R_{var}$) variable, l'équipement (26) de mesurage à tension de terre, l'équipement (28) de mesurage de courant et l'unité de compte (30) sont conçus comme unité structurelle (20) ou **en ce que** la résistance de test ($R_{var}$) variable, l'équipement (26) de mesurage à tension de terre, l'équipement (28) de mesurage de courant, l'unité de compte (30) et l'équipement (24) de mesurage à tension de réseau sont conçus comme unité structurelle expansée (21).

7. Dispositif de mesure (20, 21) selon la revendication 5 ou la revendication 6,
**caractérisé en ce que**
la résistance de test ($R_{var}$) variable est configurée comme réseau de résistance ayant des valeurs de résistance discrètement commutables ou comme résistance électronique ayant des éléments structurels semi-conducteurs.

**Fig. 1**
**Stand der Technik**

EP 4 089 423 B1

Fig. 2

EP 4 089 423 B1

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3641087 A1

- DD 256925 A1